# EUROPÄISCHE PATENTSCHRIFT

(11) **EP 0 992 069 B1**
(45) Veröffentlichungstag und Bekanntmachung des Hinweises auf die Patenterteilung: **04.09.2002**
(21) Anmeldenummer: 98936165.4
(22) Anmeldetag: 15.06.1998
(51) Int. Cl.: H01L 29/86, H02H 9/00

(54) **HALBLEITER-STROMBEGRENZER**
SEMICONDUCTOR CURRENT LIMITER
LIMITEUR DE COURANT A SEMI-CONDUCTEUR

(30) Priorität: 24.06.1997 DE 19726678
(43) Veröffentlichungstag der Anmeldung: 12.04.2000
(73) Patentinhaber: SiCED Electronics Development GmbH & Co KG, 91052 Erlangen (DE)
(72) Erfinder: BARTSCH, Wolfgang, D-91054 Erlangen (DE); MITLEHNER, Heinz, D-91080 Uttenreuth (DE); STEPHANI, Dietrich, D-91088 Bubenreuth (DE)
(74) Vertreter: Berg, Peter
(86) Internationale Anmeldenummer: DE9801619
(87) Internationale Veröffentlichungsnummer: WO98059377

(56) Entgegenhaltungen:
- WO-A-95/07548
- WO-A-96/19831
- WO-A-97/23911
- DE-U- 9 411 601
- FR-E- 92 860

## Beschreibung

Die Erfindung betrifft eine Halbleiteranordnung, die zum passiven Begrenzen eines elektrischen Stromes geeignet ist, sowie deren Verwendung.

Zum Versorgen eines elektrischen Verbrauchers (Gerätes) mit einem elektrischen Strom wird der Verbraucher über ein Schaltgerät mit einem Leitungsabzweig eines elektrisches Versorgungsnetzes verbunden. Zum Schutz des Verbrauchers vor zu hohen Strömen, insbesondere im Kurzschlußfall, wird in der Niederspannungsschalttechnik ein Schaltgerät mit einem den Leitungsabzweig schützenden Trenner, für den im allgemeinen eine Schmelzsicherung verwendet wird, und mit einem mechanischen Leistungsschalter mit einer Schaltzeit von deutlich mehr als einer Millisekunde (1 ms) eingesetzt. Werden in einem Leitungsabzweig mehrere Verbraucher gleichzeitig betrieben und tritt bei nur einem dieser Verbraucher ein Kurzschluß auf, so ist es von großem Vorteil, wenn die nicht mit dem Kurzschluß behafteten Verbraucher ungestört weiterarbeiten können und nur der vom Kurzschluß betroffene Verbraucher abgeschaltet wird. Zu diesem Zweck sind unmittelbar vor jeden Verbraucher geschaltete strombegrenzende Bauelemente ("Limiter") notwendig, die jeweils innerhalb einer Zeit von deutlich weniger als 1 ms und somit vor dem Auslösen des für den Leitungsabzweig vorgesehenen Trenners den Strom von dem prospektiven Kurzschlußstrom sicher auf einen vorgegebenen, nicht kritischen Überstromwert begrenzen. Diese strombegrenzenden Bauelemente sollten überdies passiv ohne Ansteuerung arbeiten und die im Strombegrenzungsfall anstehenden Spannungen von üblicherweise bis zu 700 V und bisweilen bis zu 1200 V aushalten können. Da die dann im Bauelement entstehende Verlustleistung sehr hoch ist, wäre es besonders vorteilhaft, wenn der passive Strombegrenzer zusätzlich den Strom auf Werte deutlich unterhalb des vorgegebenen Überstromwertes unter zusätzlicher Aufnahme von Spannung selbsttätig reduzieren würde (eigensicheres Bauelement).

Der einzige am Markt erhältliche passive Strombegrenzer ist das in dem Aufsatz *"Polyäthylen-Stromwächter für den Kurzschlußschutz" von T. Hansson, ABB Technik 4*/*92, Seiten 35-38* beschriebene Gerät mit dem Produktnamen PROLIM, das auf einer stromabhängigen Leitfähigkeit der Korngrenzen des in diesem Gerät eingesetzten Materials beruht. Jedoch kann bei häufigerem Gebrauch des Geräts zur Strombegrenzung eine Änderung des Stromsättigungswertes, bei dem der Strom begrenzt wird, auftreten.

In der *WO-A-96*/*19831* und in der *WO-A-95*/*07548* wird jeweils ein passiver Strombegrenzer beschrieben. Die offenbarten Halbleiteranordnungen weisen jeweils ein erstes Halbleitergebiet auf, in dem weitere Halbleitergebiete angeordnet sind, die jeweils mit dem ersten Halbleitergebiet einen p-n-Übergang bilden. Zwischen den weiteren Halbleitergebieten sind innerhalb des ersten Halbleitergebiets jeweils vertikale Kanalgebiete vorhanden, die zur Strombegrenzung dienen. Die weiteren Halbleitergebiete sind nicht gesondert kontaktiert. Sie sind vielmehr entweder floatend innerhalb des ersten Halbleitergebiets angeordnet oder gemeinsam mit dem ersten Halbleitergebiet kontaktiert. Mit diesen Halbleiteranordnungen läßt sich der Strom zwar passiv auf einen Sättigungsstromwert begrenzen, allerdings bleibt dieser relativ hohe Sättigungsstrom auch bei weiter steigender Spannung erhalten. Dadurch besteht die Gefahr, daß die Halbleiteranordnungen zerstört werden.

Ansonsten werden im allgemeinen nur aktive Strombegrenzer eingesetzt, die den Strom erfassen und bei Überschreiten eines vorgegebenen Maximalstromwertes durch aktives Steuern begrenzen. Aus *DE-U-9411601* ist ein solcher aktiver Strombegrenzer auf Halbleiterbasis bekannt. Dieser weist ein erstes Halbleitergebiet eines vorgegebenen Leitungstyps auf, dem an voneinander abgewandten Oberflächen jeweils eine Elektrode zugeordnet sind. In dem ersten Halbleitergebiet sind nun zwischen den beiden Elektroden weitere Halbleitergebiete vom entgegengesetzten Leitungstyp voneinander beabstandet angeordnet. Zwischen den weiteren Halbleitergebieten sind jeweils Kanalgebiete des ersten Halbleitergebietes gebildet, die senkrecht zu den beiden Oberflächen des ersten Halbleitergebietes gerichtet sind (vertikale Kanäle). Ein vertikaler Stromfluß zwischen den beiden Elektroden wird durch diese Kanalgebiete geführt und dadurch begrenzt. Zur Steuerung des Stromflusses zwischen den beiden Elektroden wird an die entgegengesetzt dotierten Halbleitergebiete in dem ersten Halbleitergebiet eine Gatespannung angelegt, durch die die Widerstände der Kanalgebiete gesteuert werden.

Ein weiterer passiver oder aktiver Strombegrenzer ist mit der nicht vorveröffentlichten *WO-A-97*/*23911* vorgeschlagen worden. Bei dieser Halbleiteranordnung wird der in einem ersten Halbleitergebiet eines ersten Leitungstyps verlaufende Strompfad in einem Kanalgebiet, das zwischen einem zweiten und dritten Halbleitergebiet mit jeweils zum ersten Leitungstyp entgegengesetzten Leitungstyp liegt, abgeschnürt. Insbesondere für die passive Ausführungsform ist jedoch in der WO-A-97/23911 keine Aussage über die Kontaktierung des dritten Halbleitergebiets enthalten.

Der Erfindung liegt nun die Aufgabe zugrunde, eine Halbleiteranordnung anzugeben, die zum sicheren und passiven Begrenzen von elektrischen Strömen bei Überschreiten eines kritischen Stromwertes eingesetzt werden kann. Es soll auch eine Strombegrenzeranordnung mit einer solchen Halbleiteranordnung angegeben werden.

Diese Aufgabe wird gemäß der Erfindung gelöst mit den Merkmalen des Anspruchs 1 oder des Anspruchs 3.

Die Halbleiteranordnung gemäß Anspruch 1 umfaßt
a) ein erstes Halbleitergebiet mit einer ersten Oberfläche und mit wenigstens einem Kontaktgebiet an dieser ersten Oberfläche,
b) wenigstens ein zweites Halbleitergebiet, das mit dem ersten Halbleitergebiet einen ersten p-n-Übergang bildet,
c) wenigstens ein drittes Halbleitergebiet, das an der ersten Oberfläche des ersten Halbleitergebietes angeordnet ist und mit dem ersten Halbleitergebiet einen zweiten p-n-Übergang bildet,
d) eine erste Elektrode, die sowohl das wenigstens eine Kontaktgebiet des ersten Halbleitergebiet als auch das dritte Halbleitergebiet an seiner nicht an das erste Halbleitergebiet angrenzenden Oberfläche kontaktiert,
e) eine zweite Elektrode, die das erste Halbleitergebiet ohmsch kontaktiert, und
f) wenigstens ein Kanalgebiet, das innerhalb eines zwischen den beiden Elektroden durch das erste Halbleitergebiet verlaufenden Strompfads liegt, wobei
g) das Kanalgebiet von dem ersten und dem zweiten p-n-Übergang derart umgeben ist, daß bei Erreichen eines vorgegebenen Sättigungsstromes zwischen den beiden Elektroden eine Abschnürung des Kanalgebiets zwischen dem zweiten und dritten Halbleitergebiet mittels Verarmungszonen der beiden p-n-Übergänge erfolgt und der Strom nach erfolgter Abschnürung auf einen Begrenzungsstrom unterhalb des Sättigungsstromes sinkt.

Die Halbleiteranordnung gemäß Anspruch 3 umfaßt
a) ein erstes Halbleitergebiet mit einer ersten Oberfläche und mit wenigstens einem Kontaktgebiet an dieser ersten Oberfläche,
b) wenigstens ein zweites Halbleitergebiet, das mit dem ersten Halbleitergebiet einen p-n-Übergang bildet,
c) eine erste Elektrode, die auf jedem Kontaktgebiet des ersten Halbleitergebietes jeweils einen ohmschen Kontakt bildet,
e) eine zweite Elektrode, die das erste Halbleitergebiet an seiner zweiten Oberfläche kontaktiert, und
f) wenigstens ein Kanalgebiet, das innerhalb eines zwischen den beiden Elektroden durch das erste Halbleitergebiet verlaufenden Strompfads liegt, wobei
g) die erste Elektrode auf einem außerhalb des wenigstens einen Kontaktgebietes liegenden Bereich des ersten Halbleitergebietes einen Schottky-Kontakt bildet,
h) das Kanalgebiet von dem ersten p-n-Übergang und dem Schottky-Kontakt derart umgeben ist, daß bei Erreichen eines vorgegebenen Sättigungsstromes zwischen den beiden Elektroden eine Abschnürung des Kanalgebiets zwischen dem zweiten Halbleitergebiet und dem Schottky-Kontakt mittels Verarmungszonen des p-n-Übergangs bzw. des Schottky-Kontakts erfolgt und der Strom nach erfolgter Abschürung auf einen Begrenzungsstrom unterhalb des Sättigungsstromes sinkt.

Diese Halbleiteranordnung gemäß Anspruch 1 oder Anspruch 3 begrenzt durch eine vorteilhafte Kombination von physikali schen Effekten im Kanalgebiet selbsttätig einen Strom, insbesondere einen Kurzschlußstrom, auf einen akzeptablen Stromwert, den Sperrstrom (Begrenzungsstrom).

Vorteilhafte Ausgestaltungen und Weiterbildungen der Halbleiteranordnung ergeben sich aus den vom Anspruch 1 oder Anspruch 3 abhängigen Ansprüchen. Vorteilhafte Verwendungen der Halbleiteranordnung für Strombegrenzeranordnungen ergeben sich aus den abhängigen Ansprüchen 19 und 20.

In einer besonders vorteilhaften und besonders durchbruchsfesten Ausführungsform der Halbleiteranordnung ist das zweite Halbleitergebiet innerhalb des ersten Halbleitergebietes unterhalb des Kontaktgebiets angeordnet ist und verläuft in allen Richtungen parallel zur Oberfläche des ersten Halbleitergebiets weiter als das Kontaktgebiet. Wegen der Ladungsspeicherung im zweiten Halbleitergebiet und der daraus resultierenden anhaltenden Abschnürung des Kanalgebietes auch bei anschließenden Spannungsabnahmen an den beiden Elektroden ist die Halbleiteranordnung nun imstande, den Sperrstrom als akzeptablen Stromwert über eine vorgegebene Sperrzeit (Begrenzungszeit) im wesentlichen beizubehalten.

Die Relaxationszeit (Ladungsabklingzeit) der im zweiten Halbleitergebiet gespeicherten Ladungen und damit die Begrenzungszeit in der stromlimitierenden Kennlinie der Halbleiteranordnung können nun gezielt eingestellt werden, indem eine elektrische Ankopplung zwischen der ersten Elektrode und dem zweiten Halbleitergebiet hergestellt wird. Die Impedanz dieser Ankopplung bestimmt dann die Relaxationszeit. Insbesondere kann die erste Elektrode direkt oder über eine an der Halbleiteranordnung oder getrennt dazu vorgesehene elektrische Ankoppelschaltung mit einer freien Oberfläche des zweiten Halbleitergebietes kontaktiert werden. Zur Einstellung der Ankoppelimpedanz kann insbesondere ein höherer ohmscher Widerstand zwischen dem zweiten Halbleitergebiet und dem Kontaktgebiet gewählt werden, beispielsweise durch Zwischenschalten einer leitenden Polysilicium-Verbindung.

Ein vertikaler und dadurch besonders spannungsfester Aufbau der Halbleiteranordnung wird dadurch erreicht, daß die zweite Elektrode an einer zweiten Oberfläche des ersten Halbleitergebietes angeordnet ist, die von der ersten Oberfläche abgewandt ist.

Vorzugsweise sind an der ersten Oberfläche des ersten Halbleitergebietes mehrere Kontaktgebiete vorgesehen, denen die erste Elektrode als gemeinsame Elektrode zugeordnet ist.

Es kann nun unterhalb der Kontaktgebiete ein zusammenhängendes zweites Halbleitergebiet angeordnet sein, das in allen Richtungen parallel zur ersten Oberfläche des ersten Halbleitergebietes weiter ausgedehnt ist als die Gesamtheit der Kontaktgebiete und vorzugsweise Öffnungen aufweist, durch die elektrisch in Reihe zu den genannten Kanalgebieten geschaltete weitere Kanalgebiete im ersten Halbleitergebiet, vorzugsweise vertikal, verlaufen.

Es können aber auch unterhalb jedes Kontaktgebietes jeweils ein zugehöriges zweites Halbleitergebiet im ersten Halbleitergebiet angeordnet sein, zwischen denen zusätzliche Kanalgebiete des ersten Halbleitergebietes verlaufen, die im Strompfad elektrisch in Reihe zu jeweils wenigstens einem der den Kontaktgebieten zugeordneten Kanalgebieten liegen.

Jedes Kontaktgebiet hat vorzugsweise eine höhere Ladungsträgerkonzentration als die übrigen Bereiche des ersten Halbleitergebietes.

Als Halbleiter für die Halbleiteranordnung wird vorzugsweise ein Halbleiter mit einem Bandabstand von mindestens 2 eV verwendet, der sich durch eine niedrige intrinsische Ladungsträgerkonzentration (Ladungsträgerkonzentration ohne Dotierung) auszeichnet, die wiederum den Ladungsspeichereffekt positiv beeinflußt.

Der Ladungsspeicherungseffekt ist besonders groß, wenn als Halbleitermaterial für die Halbleitergebiete der Halbleiteranordnung Siliciumcarbid (SiC) vorgesehen ist, da SiC eine extrem niedrige intrinsische Ladungsträgerkonzentration aufweist. Weitere Vorteile von SiC sind seine hohe Durchbruchsfestigkeit, geringe Verlustleistung, hohe Temperaturbeständigkeit, chemische Resistenz und hohe Wärmeleitfähigkeit. Bevorzugte Polytypen des SiC sind der 4H-, der 6H- und der 3C-Polytyp. Bevorzugte Dotierstoffe für SiC sind Bor und Aluminium für p-Dotierung und Stickstoff für n-Dotierung. Es sind jedoch auch andere Halbleiter geeignet, insbesondere Silicium (Si).

Ein gut geeignetes Material für die erste Elektrode ist Nikkel (Ni). Andere Materialien wie Polysilicium oder ein Metall, vorzugsweise Tantal (Ta), Titan (Ti) oder Wolfram (W), sind ebenfalls geeignet.

Ein Gleichstrombegrenzer wird realisiert, indem eine Elektrode der Halbleiteranordnung mit der Stromquelle und die andere Elektrode mit dem Verbraucher elektrisch verbindbar ist.

Ein Wechselstrombegrenzer wird in vorteilhafter Weise durch antiserielles Verschalten zweier Halbleiteranordnungen zwischen die Stromquelle und den elektrischen Verbraucher verwirklicht. Die Ladungsspeicherung in den zweiten Halbleitergebieten verhindert, daß der Strom bei Polaritätswechsel der Wechselspannung immer wieder angeschaltet wird.

Ausführungsbeispiele der Erfindung werden anhand der Zeichnung erläutert. Diese zeigt in ihrer
- FIG 1: eine Ausführungsform einer Halbleiteranordnung mit einem lateralen Kanalgebiet, das von einem p-n-Übergang nach unten und einem Schottky-Kontakt nach oben begrenzt wird,
- FIG 2: eine Halbleiteranordnung mit einem lateralen Kanalgebiet, das von zwei p-n-Übergangen begrenzt wird,
- FIG 3: eine Ausführungsform einer Halbleiteranordnung mit lateralen und vertikalen Kanalgebieten,
- FIG 4: eine Halbleiteranordnung mit einem Zelldesign in einer Draufsicht,
- FIG 5: eine Halbleiteranordnung mit am Rand elektrisch kontaktierten vergrabenen Halbleitergebieten,
- FIG 6: ein Wechselstrombegrenzer mit zwei antiseriell geschalteten Halbleiteranordnungen,
- FIG 7: eine gemessene Kennlinie eines Wechselstrombegrenzers gemäß FIG 6
und

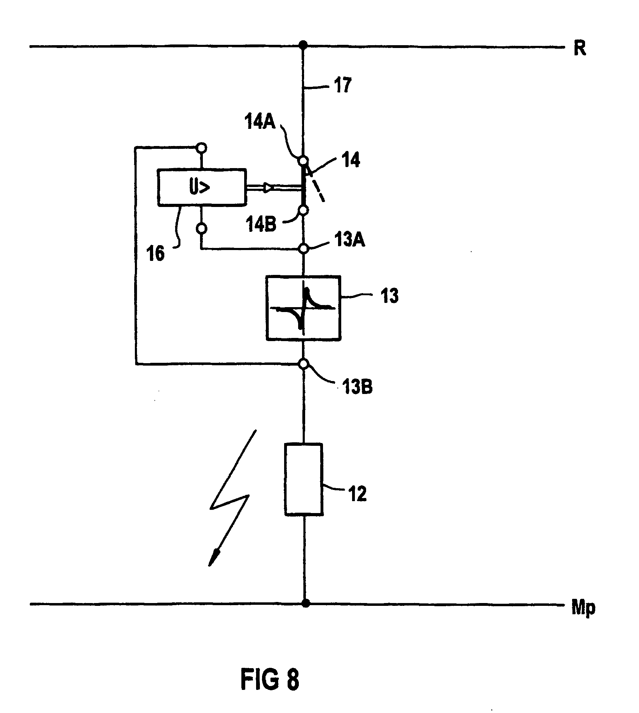

- FIG 8: eine Schalteinrichtung mit einem Strombegrenzer in einem Leitungsabzweig.

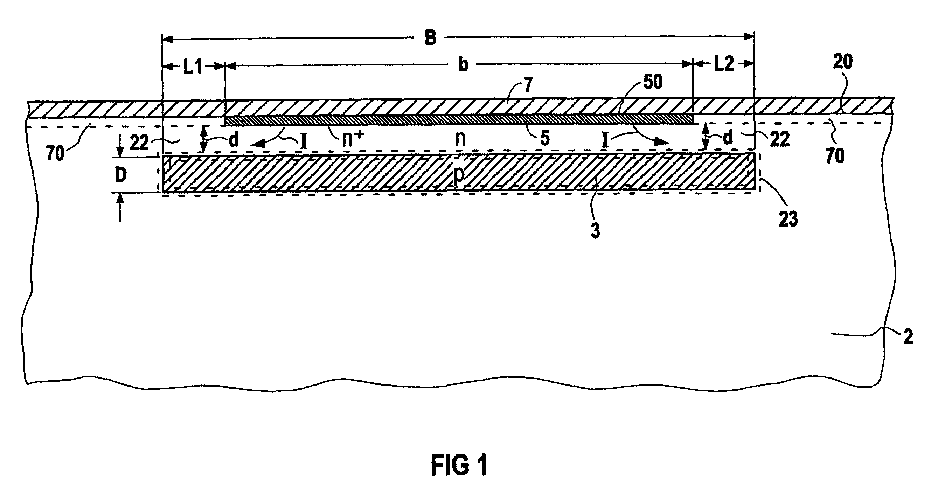

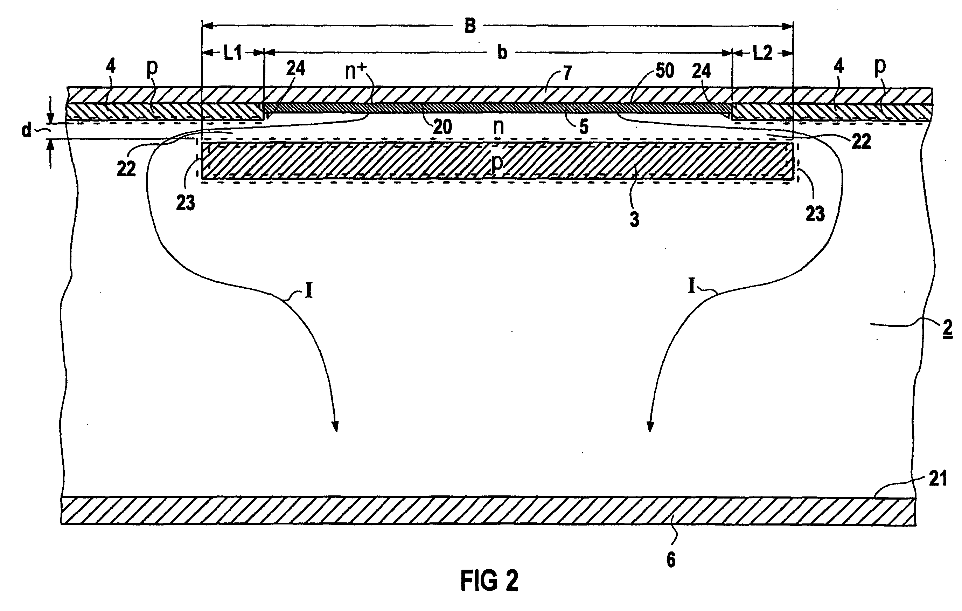

Die in den FIG 1 und 2 dargestellten Halbleiteranordnungen umfassen jeweils ein erstes Halbleitergebiet 2 vom n-Leitungstyp (Elektronenleitung) und ein zweites Halbleitergebiet 3 vom p-Leitungstyp (Löcherleitung). Das erste Halbleitergebiet 2 weist eine planare (ebene) Oberfläche 20 auf. Das zweite Halbleitergebiet 3 ist unterhalb dieser Oberfläche 20 innerhalb des ersten Halbleitergebiets 2 angeordnet (vergraben) und verläuft wenigstens an seiner der Oberfläche 20 des ersten Halbleitergebiets 2 zugewandten Seite lateral, d.h. im wesentlichen parallel zur Oberfläche 20 des ersten Halbleitergebiets 2. Vorzugsweise wird das zweite Halbleitergebiet 3 durch Ionenimplantation von Dotierstoffteilchen in die Oberfläche 20 des ersten Halbleitergebiets 2 erzeugt. Ein gewünschtes Dotierprofil wird durch das Eindringprofil bei der Ionenimplantation mittels der lonenenergie unter Berücksichtigung etwaiger Implantationsmasken eingestellt. Insbesondere ergeben sich daraus die Tiefe des zweiten Halbleitergebietes 3, d.h. der Abstand dieses zweiten Halbleitergebietes 3 von der Oberfläche 20 des ersten Halbleitergebietes 2 und die vertikale, d.h. senkrecht zur Oberfläche 20 des ersten Halbleitergebiets 2 gemessene, Ausdehnung D des zweiten Halbleitergebiets 3. Diese vertikale Ausdehnung D beträgt insbesondere zwischen 0,1 µm und 1,0 µm. Die laterale Ausdehnung des zweiten Halbleitergebiets 3 parallel zur Oberfläche 20 des ersten Halbleitergebiets 2 im dargestellten Querschnitt ist mit B bezeichnet und im allgemeinen zwischen 10 µm und 30 µm gewählt. Zwischen dem ersten Halbleitergebiet 2 und dem entgegengesetzt dotierten zweiten Halbleitergebiet 3 ist ein p-n-Übergang gebildet, dessen Verarmungszone (Raumladungszone) mit 23 bezeichnet ist und gestrichelt eingezeichnet ist. Die Verarmungszone 23 des p-n-Übergangs umgibt das gesamte zweite Halbleitergebiet 3. Die Ausdehnung einer Verarmungszone eines p-n-Übergangs in das p-Gebiet und das n-Gebiet richtet sich dabei bekanntlich nach der Maßgabe der sich aus den Dotierkonzentrationen ergebenden Ladungsträgerkonzentrationen gemäß dem Poisson-Gesetz und dem Prinzip der Ladungserhaltung sowie der am p-n-Übergang anliegenden Spannung (Potentialdifferenz).

An der Oberfläche 20 des ersten Halbleitergebiets 2 ist gemäß FIG 1 und FIG 2 ein Kontaktgebiet 5 zum ohmschen Kontaktieren vorgesehen. Das Kontaktgebiet 5 ist vorzugsweise höher dotiert und vom gleichen Leitungstyp wie das erste Halbleitergebiet 2, im dargestellten Ausführungsbeispiel durch n⁺ angedeutet. Die laterale Ausdehnung des Kontaktgebiets 5 im dargestellten Querschnitt ist mit b bezeichnet und ist in allen Richtungen parallel zur Oberfläche 20 des ersten Halbleitergebiets 2 kleiner als die laterale Ausdehnung B des zweiten Halbleitergebiets 3. Üblicherweise liegt die laterale Ausdehnung b des Kontaktgebietes zwischen 6 µm und 28 µm. Das zweite Halbleitergebiet 3 und das Kontaktgebiet 5 sind relativ zueinander so angeordnet, daß in einer Projektion senkrecht zur Oberfläche 20 des ersten Halbleitergebiets 2 die Projektion des Kontaktgebiets 5 vollständig innerhalb der Projektion des zweiten Halbleitergebiets 3 liegt.

Auf einer freien Oberfläche 50 des Kontaktgebiets 5 ist eine erste Elektrode 7 aus einem elektrisch leitenden Material angeordnet. Die erste Elektrode 7 erstreckt sich auch über die angrenzende Halbleiteroberfläche.

In der Ausführungsform gemäß FIG 1 bildet die erste Elektrode 7 nun auf dem Kontaktgebiet 5 einen ohmschen Kontakt und auf der Oberfläche 20 des ersten Halbleitergebietes 2 einen Schottky-Kontakt, dessen Verarmungszone (Sperrschicht) mit 70 bezeichnet ist und gestrichelt eingezeichnet ist. Dies kann beispielsweise durch eine geeignete Einstellung der Ladungsträgerkonzentrationen des Kontaktgebietes 5 und des ersten Halbleitergebietes 2 beim Dotieren erreicht werden. Das erste Halbleitergebiet 2 und das Kontaktgebiet 5 bestehen jeweils aus dem besonders vorteilhaften Halbleitermaterial Siliciumcarbid (SiC), wobei man insbesondere die Dotierstoffkonzentration des Kontaktgebietes 5 über etwa 1·10¹⁹ cm⁻³ und des ersten Halbleitergebietes 2 kleiner als etwa 2·10¹⁶ cm⁻³ wählt. Vorteilhaft ist für die erste Elektrode 7 dann Nickel- (Ni) als Material vorgesehen.

In der Ausführungsform gemäß FIG 2 ist dagegen an der Oberfläche 20 des ersten Halbleitergebietes 2 ein drittes Halbleitergebiet 4 angeordnet, das vom entgegengesetzten Leitungstyp wie das erste Halbleitergebiet 2 ist, also im dargestellten Ausführungsbeispiel vom p-Leitungstyp, und vorzugsweise ebenfalls durch Ionenimplantation erzeugt ist. Zwischen dem ersten Halbleitergebiet 2 und dem dritten Halbleitergebiet 4 ist ein p-n-Übergang gebildet, dessen Verarmungszone mit 24 bezeichnet ist und gestrichelt eingezeichnet ist. Die erste Elektrode 7 erstreckt sich auch über das dritte Halbleitergebiet 4 und bildet sowohl auf dem Kontaktgebiet 5 als auch auf dem dritten Halbleitergebiet 4 einen ohmschen Kontakt.

Zwischen dem an der ersten Oberfläche 20 des ersten Halbleitergebietes 2 angeordneten, mit der ersten Elektrode 7 gebildeten Schottky-Kontakt gemäß FIG 1 oder dem dritten Halbleitergebiet 4 gemäß FIG 2 einerseits und dem vergrabenen zweiten Halbleitergebiet 3 andererseits ist jeweils ein lateral sich erstreckendes halbleitendes Kanalgebiet 22 im ersten Halbleitergebiet 2 gebildet. Die lateralen Ausdehnungen L1 und L2 des Kanalgebietes 22 auf unterschiedlichen Seiten des Kontaktgebiets 5 können gleich oder auch unterschiedlich groß sein. Typischerweise betragen die Kanallängen L1 und L2 zwischen 1 µm und 5 µm. Die vertikale, d.h. im wesentlichen senkrecht zur Oberfläche 20 gerichtete, Ausdehnung des Kanalgebietes 22 ist im allgemeinen zwischen 0,1 µm und 1 µm gewählt. Da die in das Kanalgebiet 22 sich erstreckenden Verarmungszonen 23 und 70 in FIG 1 und 23 und 24 in FIG 2 durch die starke Verarmung an Ladungsträgern einen wesentlich höheren elektrischen Widerstand als das erste Halbleitergebiet 2 aufweisen, ist im wesentlichen nur der Innenbereich des Kanalgebietes 22 stromtragfähig, der nach unten durch die Verarmungszone 23 und nach oben durch die Verarmungszone 70 in FIG 1 bzw. 24 in FIG 2 begrenzt ist. Die vertikale Ausdehnung dieses stromführenden Innenbereichs des Kanalgebiets 22 ist mit d bezeichnet.

In FIG 2 ist das dritte Halbleitergebiet 4 derart lateral versetzt zum zweiten Halbleitergebiet 3 angeordnet, daß sich die beiden Halbleitergebiete 3 und 4 entlang der Kanallänge L1 auf einer Seite und der Kanallänge L2 auf der anderen Seite in einer Projektion auf die Oberfläche 20 des ersten Halbleitergebiets 2 überlappen. Das dritte Halbleitergebiet 4 umschließt lateral das Kontaktgebiet 5 und grenzt unmittelbar an das Kontaktgebiet 5 an, so daß L1 + b +L2 = B für die lateralen Ausdehnungen L1, L2, b und B gilt. Das Kontaktgebiet 5 kann aber auch von dem dritten Halbleitergebiet 4 lateral beabstandet sein.

Bei beiden Ausführungsformen gemäß FIG 1 und FIG 2 ist nun des weiteren eine nur in FIG 2 dargestellte zweite Elektrode 6 vorgesehen, die derart angeordnet ist, daß das Kanalgebiet 22 im Strompfad zwischen den beiden Elektroden liegt. Diese zweite Elektrode ist kann beispielsweise an der ersten Oberfläche 20 des ersten Halbleitergebietes 2 angeordnet sein (lateraler Aufbau) oder wie in FIG 2 gezeigt an einer von der ersten Oberfläche 20 des ersten Halbleitergebietes 2 abgewandten weiteren Oberfläche 21 des ersten Halbleitergebietes 2 angeordnet sein (vertikaler Aufbau).

Zwischen der zweiten Elektrode 6 und der ersten Elektrode 7 wird eine Betriebsdurchlaßspannung an die Halbleiteranordnung angelegt. In den Ausführungsbeispielen gemäß FIG 1 und FIG 2 werden die erste Elektrode 7 mit der Kathode und die zweite Elektrode 6 mit der Anode der Betriebsspannungsquelle verbunden. Bei Vertauschung der Leitungstypen der Halbleitergebiete wird die Polarität der Betriebsspannung entsprechend vertauscht.

Das Verhalten der Halbleiteranordnung bei Anliegen einer Betriebsdurchlaßspannung ist nun abhängig von dem durch die Halbleiteranordnung fließenden elektrischen Strom I zwischen den Elektroden 6 und 7. Dieser elektrische Strom I fließt zwischen den beiden Elektroden 6 und 7 entlang eines durch Pfeile angedeuteten Strompfades zunächst im wesentlichen lateral durch das Kanalgebiet 22 im ersten Halbleitergebiet 2 und dann, im Ausführungsbeispiel gemäß FIG 2 weitgehend vertikal, durch den Volumenbereich des ersten Halbleitergebietes 2. Mit steigender Stromstärke I wächst der Durchlaßspannungsabfall zwischen den Elektroden 6 und 7, so daß das zweite Halbleitergebiet 3 und der Schottky-Kontakt gemäß FIG 1 bzw. das dritte Halbleitergebiet 4 gemäß FIG 2 negativ gegen die zweite Elektrode 6 vorgespannt werden. Der erhöhte Durchlaßspannungsabfall wirkt als höhere Sperrspannung an dem p-n-Übergang zwischen dem ersten Halbleitergebiet 2 und dem zweiten Halbleitergebiet 3 und an dem Schottky-Kontakt gemäß FIG 1 bzw. dem dritten Halbleitergebiet 4 gemäß FIG 2 und führt damit zu einer Vergrößerung der Verarmungszonen 23 und 70 bzw. 24. Dies hat eine Verminderung des Querschnitts und eine entsprechende Widerstandserhöhung des halbleitenden Bereichs des Kanalgebiets 22 zur Folge. Bei Erreichen eines bestimmten kritischen Stromwertes (Sättigungsstrom) I_{Sat} berühren sich die Verarmungszonen 23 und 70 bzw. 24 und schnüren das Kanalgebiet 22 vollständig ab. Wegen des nun erheblich höheren elektrischen Widerstandes im Kanalgebiet 22 geht der Strom nun in Sättigung und bleibt bei gleichbleibender Spannung zwischen den Elektroden 6 und 7 auf dem Sättigungsstromwert I_{Sat}. Der Sättigungsstrom I_{Sat} der Halbleiteranordnung wird durch die geometrischen Abmessungen des Kanalgebiets 22, insbesondere dessen lateralen Ausdehnungen L1 und L2 und vertikale Ausdehnung d, sowie durch die mit der Dotierung festgelegte Ladungsträgerkonzentration des Kanalgebietes 22 auf einen gewünschten Wert eingestellt.

Falls dagegen, wie beispielsweise im Kurzschlußfall, die Spannung zwischen den Elektroden 6 und 7 weiter steigt, nachdem der Strom I bereits den Sättigungsstromwert I_{Sat} erreicht hat, steigt die elektrische Verlustleistung im Kanalgebiet 22, und das Kanalgebiet 22 erwärmt sich. Mit der steigenden internen Temperatur im Kanalgebiet 22 nimmt nun die Beweglichkeit derjenigen Ladungsträger, die in den das Kanalgebiet 22 überdeckenden Verarmungszonen 23 und 70 bzw. 24 verblieben sind, ab. Die Leitfähigkeit des Kanalgebiets 22 sinkt somit weiter, mit der Folge, daß aufgrund des resultierenden höheren Durchlaßspannungsabfalls zwischen den Elektroden 6 und 7 die beweglichen Ladungsträger aus den Verarmungszonen 23 und 70 bzw. 24 im Kanalgebiet 22 verstärkt ausgeräumt werden. Aufgrund dieses Rückkopplungseffektes begrenzt die Halbleiteranordnung auch einen stark anwachsenden elektrischen Strom wie im Kurzschlußfall schnell auf einen unkritischen Stromwert (Begrenzungsstrom) I_{B}, der deutlich unter dem Sättigungsstrom Iₛₐₜ, beispielsweise um höchstens einen Faktor 0,2 (Iₛₐₜ ≥ 5 I_{B}), liegt und bei Erreichen hoher Sperrspannungen im wesentlichen dem Sperrstrom der Halbleiteranordnung bei der gewünschten Durchbruchsspannung, die typischerweise zwischen 60 V und 1200 V (z.B. auch 700 V) liegen kann, entspricht.

In der Raumladungszone 23 um das vergrabene zweite Halbleitergebiet 3 bleibt die akkumulierte Raumladung abhängig von der intrinsischen Ladungsträgerkonzentration des Halbleiters gespeichert. Durch diese Ladungsspeicherung bleibt das elektrische Potential im zweiten Halbleitergebiet 3 auch bei wieder abnehmender Spannung zwischen den beiden Elektroden 6 und 7 weitgehend erhalten, und das Kanalgebiet 22 bleibt geschlossen. Somit wird mit der Halbleiteranordnung eine schnelle und sichere Begrenzung des Stromes I auf den Sperrstrom I_{B} erreicht.

Der Halbleiter für die Halbleitergebiete 2, 3 und 4 der Halbleiteranordnung ist Siliciumcarbid (SiC). Dadurch ist der Ladungsspeicherungseffekt besonders groß. Dotierstoffe für SiC sind Bor und Aluminium für p-Dotierung und Stickstoff für n-Dotierung.

Die Dotierungen des ersten Halbleitergebietes 2, des zweiten Halbleitergebietes 3 und des dritten Halbleitergebietes 4 bestimmen die Sperrfähigkeit der Halbleiteranordnung, wenn zwischen den beiden Elektroden 6 und 7 eine Spannung in Sperrrichtung anliegt.

Nach den genannten Ionenimplantationen der Halbleitergebiete 3, 4 und 5 werden im allgemeinen thermische Ausheilverfahren durchgeführt, um Gitterdefekte zu reduzieren. Anstelle von Ionenimplantation kann zum Herstellen des Kontaktgebietes 5 und des dritten Halbleitergebietes 4 auch ein epitaktisches Aufwachsen entsprechender Halbleiterschichten und ein anschließendes Strukturieren dieser Schichten (z.B. Mesastrukturen) oder insbesondere bei Silicium auch ein Diffusionsprozeß verwendet werden.

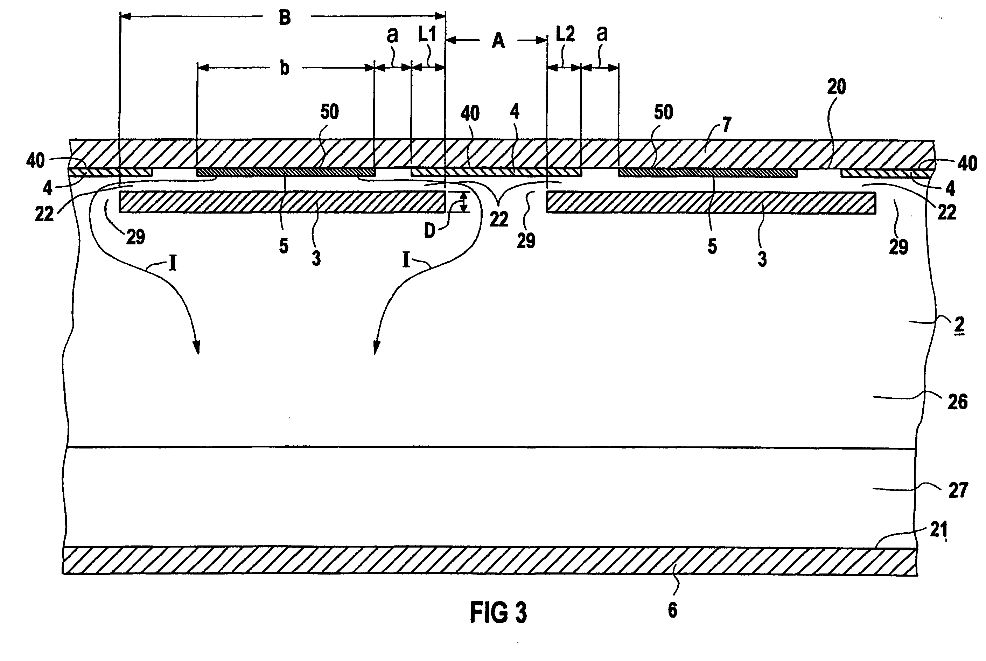

FIG 3 zeigt eine Halbleiteranordnung, bei der das erste Halbleitergebiet 2 aus einem Substrat 27 und einer darauf angeordneten, epitaktisch aufgewachsenen Halbleiterschicht 26 vom gleichen Leitungstyp und im allgemeinen einer niedrigeren Ladungsträgerkonzentration wie bzw. als das Substrat 27 zusammengesetzt ist. An der Oberfläche 20 der Halbleiterschicht 26 sind mehrere gleich, aber vorzugsweise höher als die Halbleiterschicht 26 dotierte Kontaktgebiete 5 zueinander beabstandet angeordnet, von denen nur zwei dargestellt sind. Unterhalb der Kontaktgebiete 5 ist in der Halbleiterschicht 26 jeweils ein zur Halbleiterschicht 26 entgegengesetzt dotiertes zweites Halbleitergebiet 3 oder jeweils ein Teilbereich eines zusammenhängenden dritten Halbleitergebietes 3 vergraben. Zwischen den Kontaktgebieten 5 sind jeweils in einem lateralen Abstand und vorzugsweise in einem gleichen Abstand a ein drittes, entgegengesetzt zur Halbleiterschicht 26 dotiertes Halbleitergebiet 4 an der Oberfläche 20 der Halbleiterschicht 26 angeordnet. Der laterale Abstand a der Kontaktgebiete 5 von den dritten Halbleitergebieten 4 liegt im allgemeinen zwischen 1 µm und 3µm.

Die freie Oberfläche 20 der Halbleiterschicht 26, die Kontaktgebiete 5 und die dritten Halbleitergebiete 4 sind durch eine elektrisch leitende Schicht, vorzugsweise aus Metall oder Polysilicium, als erste Elektrode 7 kontaktiert.

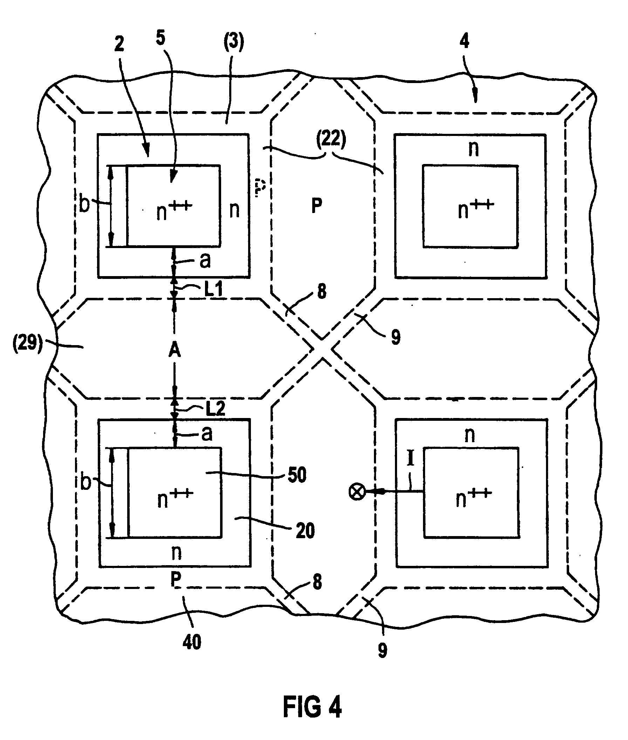

Die Halbleitergebiete 3 und 4 verlaufen jeweils im wesentlichen lateral zur Oberfläche 20 des ersten Halbleitergebiets 2. Jeweils ein Halbleitergebiet 4 überlappt in einer Projektion entlang einer Richtung senkrecht zur Oberfläche 20 mit jeweils zwei der Halbleitergebiete 3 und jedes Halbleitergebiet 3 mit jeweils zwei der Halbleitergebiete 4. Dadurch sind wie in FIG 1 wieder lateral verlaufende Kanalgebiete 22 der lateralen Kanallängen L1 bzw. L2 in der Halbleiterschicht 26 gebildet zwischen jeweils einem zweiten Halbleitergebiet 3 und jeweils einem dritten Halbleitergebiet 4. Die laterale Ausdehnung B der vergrabenen zweiten Halbleitergebiete 3 ist B = b + 2a + L1 + L2. Auf der von der Halbleiterschicht 26 abgewandten Seite des Substrats 27 als zweite Oberfläche 21 des ersten Halbleitergebiets 2 ist wieder eine Elektrode 6 angeordnet. Zwischen der Elektrode 6 und der Elektrode 7 wird die Betriebsspannung der Halbleiteranordnung angelegt. Die vergrabenen Halbleitergebiete 3 sind lateral voneinander beabstandet, vorzugsweise mit gleichem Abstand A, oder es sind in einem zusammenhängenden zweiten Halbleitergebiet 3 Öffnungen mit jeweils einer lateralen Ausdehnung A gebildet. Zwischen den zweiten Halbleitergebieten 3 ist dadurch jeweils ein Kanalgebiet 29 des ersten Halbleitergebiets 2 von der lateralen Ausdehnung A und der vertikalen Ausdehnung D gebildet, das im wesentlichen vertikal zur Oberfläche 20 verläuft. Der halbleitende Bereich in jedem Kanalgebiet 29 ist lateral begrenzt durch die nicht dargestellten Verarmungszonen der von der Halbleiterschicht 26 und den zweiten Halbleitergebieten 3 gebildeten p-n-Übergänge (auch in FIG 4 dargestellt).

Die laterale Ausdehnung A der vertikalen Kanalgebiete 29 ist vorzugsweise so klein gewählt, daß die zwischen den beiden Elektroden 6 und 7 anlegbare maximale Sperrspannung zumindest weitgehend der maximalen Volumensperrspannung entspricht, die der p-n-Übergang zwischen den Halbleitergebieten 2 und 3 an der Unterseite der zweiten Halbleitergebiete 3 tragen kann. Dies entspricht einem zumindest weitgehend planaren Verlauf der Äquipotentiallinien im Sperrfall (reduzierter Spannungsdurchgriff). Typische Werte für die laterale Ausdehnung A liegen zwischen 1 µm und 10 µm.

Bei Anlegen einer in Durchlaßrichtung gepolten Betriebsspannung fließt zwischen der Elektrode 7 und der Elektrode 6 ein Strom I entlang der dargestellten Pfeile, der zunächst durch die lateralen Kanalgebiete 22 und danach in praktisch vertikaler Richtung zur Oberfläche 20 durch die vertikalen Kanalgebiete 29 in der Halbleiterschicht 26 und dann im wesentlichen vertikal durch die Halbleiterschicht 26 und das Substrat 27 zur zweiten Elektrode 6 verläuft.

FIG 4 zeigt eine Ausführungsform einer Halbleiteranordnung in einer Draufsicht auf die Halbleiteroberfläche ohne Elektrode 7. In einem Zelldesign sind mehrere wenigstens annähernd quadratische Zellen vorgesehen aus jeweils einem als Quadrat der Seitenlänge b gebildeten und n⁺⁺-dotierten Sourcegebiet als Kontaktgebiet 5, das in einer n-dotierten Halbleiterschicht als erstem Halbleitergebiet 2 implantiert ist, einem das n⁺⁺-Kontaktgebiet 5 in einem Abstand a umgebenden p-dotierten dritten Halbleitergebiet 4 und einem unterhalb des Kontaktgebietes 5 durch Implantation vergrabenen, p-dotierten zweiten Halbleitergebiet 3, das gestrichelt dargestellt ist. Das dritte Halbleitergebiet 4 mit der Oberfläche 40 ist vorzugsweise an der gesamten Oberfläche 20 des ersten Halbleitergebietes 2 implantiert mit Ausnahme der quadratischen Aussparungen für die Kontaktgebiete 5 mit den Oberflächen 50 und die die Kontaktgebiete 5 umgebenden Teilbereiche der Oberfläche 20 des ersten Halbleitergebietes 2. In dem quadratringförmigen Überlappungsbereich der Breite L1 oder L2 ist unterhalb des dritten Halbleitergebietes 4 und oberhalb des zweiten Halbleitergebietes 3 wieder jeweils ein Kanalgebiet 22 gebildet. Um die vergrabenen zweiten Halbleitergebiete 3 auf gemeinsames Potential zu legen, sind diese zweiten Halbleitergebiete 3 über kreuzförmig verlaufende p-dotierte Verbindungen 8 und 9 im ersten Halbleitergebiet 2 miteinander verbunden. Zwischen den Verbindungen 8 und 9 und den benachbarten dritten Halbleitergebieten 3 sind jeweils ein durchgehendes, in etwa in Form einer Raute der Breite A und vertikal zur Oberfläche 40 bzw. 20 verlaufendes Kanalgebiet 29 im ersten Halbleitergebiet 2 unterhalb des dritten Halbleitergebietes 4 angeordnet. Der Strom I fließt von den Kontaktgebieten 5, die man auch als Sourcegebiete bezeichnen könnte, zunächst lateral (d.h. waagrecht oder horizontal) durch das laterale Kanalgebiet 22 und anschließend annähernd vertikal durch die benachbarten vertikalen Kanalgebiete 29.

Für den Halbleiter aus SiC werden im allgemeinen folgende Dotierstoffkonzentrationen gewählt:
Für das erste Halbleitergebiet 2, insbesondere die Halbleiterschicht 26, in einem Bereich zwischen etwa 2 · 10¹⁷ cm⁻³ (für eine Sperrspannung von etwa 60 V) über etwa 2 · 10¹⁶ cm⁻³ (für eine Sperrspannung von etwa 700 V) bis zu etwa 6 · 10¹⁵ cm⁻³ (für eine Sperrspannung von etwa 1200 V), für das Substrat 27 auch deutlich mehr als 10¹⁸ cm⁻³ und für die zweiten Halbleitergebiete 3 und die dritten Halbleitergebiete 4 zwischen etwa 1 · 10¹⁸ cm⁻³ und etwa 2 10¹⁹ cm⁻³, vorzugsweise etwa 5 · 10¹⁸ cm⁻³ sowie für das Kontaktgebiet 5 über etwa 1 · 10¹⁹ cm⁻³. Bei einer nicht dargestellten Ausführungsform mit Silicium als Halbleitermaterial sind die für SiC genannten Dotierstoffkonzentrationen im allgemeinen jeweils durch etwa 100 zu dividieren (d.h. um zwei Größenordnungen kleiner).

Alle beschriebenen Ausführungsformen der Halbleiteranordnung können in verschiedenen Topologien ausgeführt werden, insbesondere in einem Zelldesign oder auch in einer kammartigen Struktur.

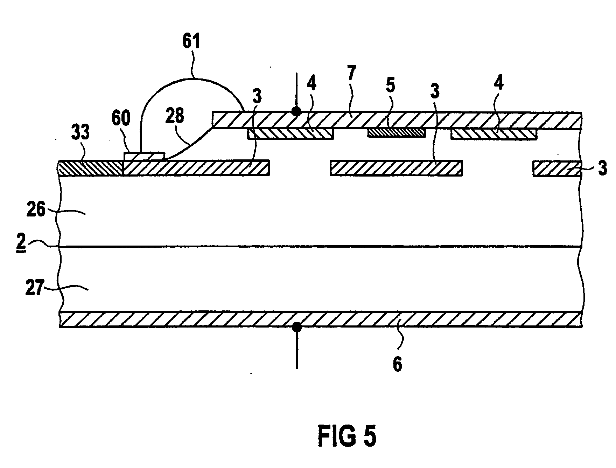

FIG 5 zeigt eine vorteilhafte Weiterbildung der Ausführungsform gemäß FIG 3. Die Halbleiterschicht 26 ist an ihrem Rand durch Abtragen von Halbleitermaterial, beispielsweise durch einen Ätzprozeß, bis zu dem zusammenhängenden, vergrabenen zweiten Halbleitergebiet 3 hinunter entfernt. Auf der freigelegten Oberfläche des zweiten Halbleitergebietes 3 ist ein Kontakt 60 aufgebracht. Dieser Kontakt 60 ist über eine elektrische Verbindung 61 mit der ersten Elektrode 7 elektrisch verbunden. Über diese elektrische Verbindung 61 sind die zweiten Halbleitergebiete 3 an die dritten Halbleitergebiete 4 an der Oberfläche 20 angekoppelt. Die elektrische Verbindung 61 kann auf der Halbleiteranordnung integriert sein oder auch eine externe Verdrahtung, insbesondere über einen Schaltkreis, sein. Durch die Wahl der elektrischen Impedanz dieser elektrischen Verbindung 61 kann eine definierte Relaxationszeit (Ladungsabflußzeit) der im zweiten Halbleitergebiet 3 gespeicherten Ladungen im Kurzschlußfall eingestellt werden. Im allgemeinen weist die elektrische Verbindung 61 einen höheren elektrischen Widerstand als die erste Elektrode 7 auf und kann dazu eine höherohmige Polysilicium-Leitungsstrecke umfassen. Im Anschluß an das freigelegte zweite Halbleitergebiet 23 ist ein den gleichen Leitungstyp, jedoch im allgemeinen eine niedrigere Ladungsträgerkonzentration als das zweite Halbleitergebiet 3 aufweisender, flächiger Randabschluß 33 vorgesehen zur Reduzierung der Feldstärke an der Oberfläche. In Abwandlung zu FIG 5 kann die Kontaktierung der vergrabenen zweiten Halbleitergebiete 3 auch in einem inneren Bereich der Halbleiteranordnung erfolgen.

Die Ausführungsformen mit Schottky-Kontakten und die Ausführungsformen mit zusätzlichen p-n-Übergängen mit den dritten Halbleitergebieten 4 an der Oberfläche 20 des ersten Halbleitergebietes 2 können auch miteinander kombiniert werden, indem zur Begrenzung des elektrischen Durchgriffs zur ersten Elektrode 7 nebeneinander Schottky-Kontakte und zusätzliche p-n-Übergänge an derselben Oberfläche 20 des ersten Halbleitergebietes 2 vorgesehen werden.

Die bisher beschriebenen Halbleiteranordnungen sind unipolare Bauelemente, die in hervorragender Weise zur Begrenzung von Kurzschlußgleichströmen geeignet sind und dabei eigensicher und ohne Ansteuerung (passiv) arbeiten. Durch die Auslegung der Halbleiteranordnung als Strombegrenzer kann ein gewünschter Sättigungsstrom I_{Sat} eingestellt werden, der oberhalb eines Nennstrombereiches und auch eines regulären, noch zu tolerierenden Überstrombereiches liegt und ab dem die Halbleiteranordnung den Strom selbsttätig unter Aufnahme von Spannung auf den niedrigeren Sperrstrom I_{B} begrenzt.

In einer nicht dargestellten, auch für Wechselspannungen geeigneten Ausführungsform eines Strombegrenzers werden eine Serienschaltung aus einer ersten Halbleiteranordnung gemäß einer der FIG 1 bis 5 und einer ersten Diode für die Rückwärtsspannung und eine weitere Serienschaltung aus einer zweiten Halbleiteranordnung gemäß einer der FIG 1 bis 5 und einer zweiten Diode für deren Rückwärtsspannung antiparallel geschaltet. Die beiden Dioden können p-n-Gleichrichterdioden oder auch Schottky-Dioden, insbesondere auf SiC-Basis, sein. Die Kennlinie dieses Wechselstrombegrenzers ist dann mit den Diodenschwellspannungen behaftet.

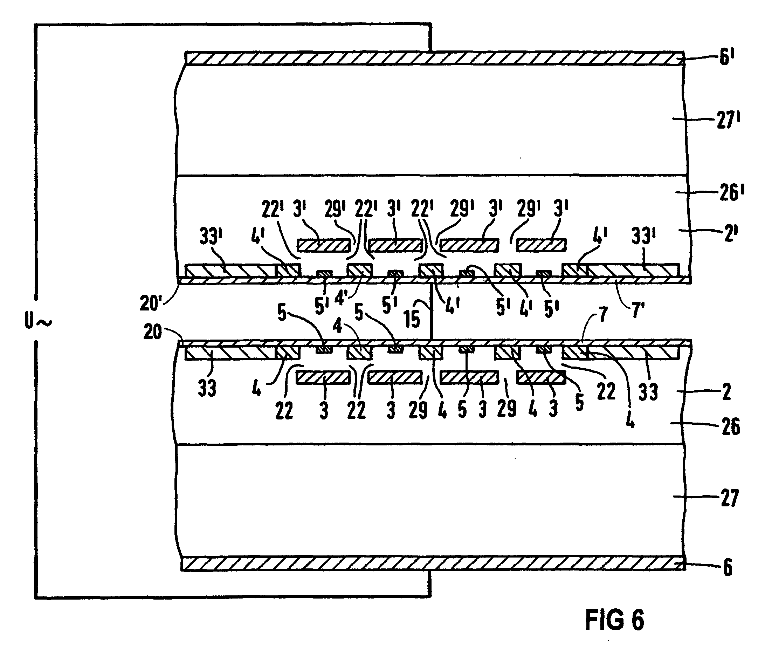

Eine besonders vorteilhafte Ausführungsform eines Wechselstrombegrenzers ist in FIG 6 dargestellt. Zwei gleichartige Halbleiteranordnungen, die ähnlich wie in FIG 3 aufgebaut sind, sind antiseriell geschaltet, so daß jeweils eine der beiden Halbleiteranordnungen eine Kurzschlußhalbwelle (Strompolarität) begrenzt. Dazu sind die ersten Elekroden 7 und 7' der beiden Halbleiteranordnungen elektrisch über eine elektrische Verbindung 15 miteinander kontaktiert und die beiden zweiten Elektroden 6 und 6' jeweils mit einem Pol der Wechselspannung elektrisch verbunden. Die äußersten dritten Halbleitergebiete 4 bzw. 4' sind von einem entgegengesetzt zur Halbleiterschicht 26 bzw. 26' dotierten flächigen Randabschluß 33 umgeben zur Reduzierung der Feldstärke an der Oberfläche 20 bzw. 20' und Passivierung. Der Ladungsspeichereffekt in den zweiten Halbleitergebieten 3 und 3' verhindert im Kurzschlußfall ein wiederholtes Anschalten während der folgenden Wechselspannungsperioden, so daß der Strom auf den niedrigen Sperrstrom I_{B} begrenzt bleibt.

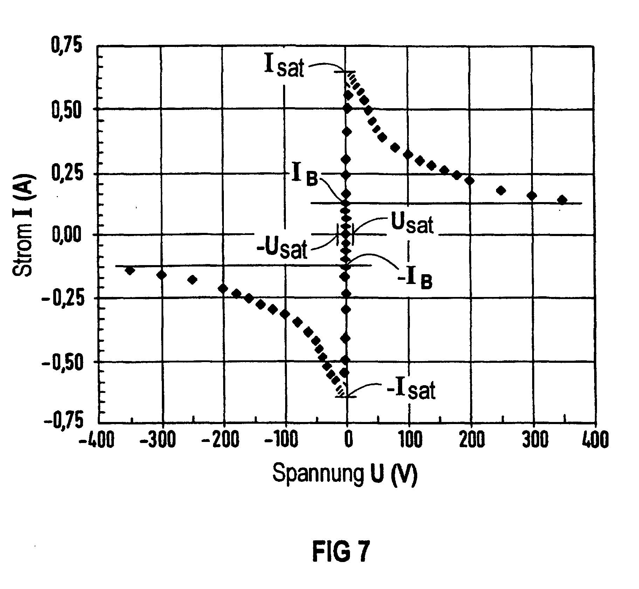

Die gemessene Strom-Spannungs-Kennlinie eines in SiC gebildeten Wechselstrombegrenzers gemäß FIG 6 ist in FIG 7 gezeigt. Diese Kennlinie zeigt die hervorragende Eignung der Halbleiteranordnung als stromlimitierendes Bauelement. In einem Nennstrombereich über einem Nennspannungsbereich um 0V zeigt der Wechselstrombegrenzer ein ohmsches Verhalten mit sehr geringem Durchlaßwiderstand und dadurch auch sehr geringen Durchlaßverlusten. Bei Erreichen eines Sättigungsstromes Iₛₐₜ bei einer positiven Sättigungsspannung +Uₛₐₜ und -Iₛₐₜ bei negativer Spannung -Uₛₐₜ wird der Strom I auf einen Begrenzungsstrom +I_{B} bzw. -I_{B} begrenzt, wenn die Spannung U betragsmäßig weiter wächst wie im Kurzschlußfall.

FIG 7 veranschaulicht eine Schalteinrichtung in einem Leitungsabzweig 17 zwischen einer Phase R und Erdpotential Mp eines elektrischen Versorgungsnetzes, beispielsweise einer Gebäudeinstallation, für einen elektrischen Verbraucher 12. Die Schalteinrichtung umfaßt einen elektronischen Strombegrenzer 13, der insbesondere gemäß einer der FIG 1 bis 6 ausgebildet sein kann, einen Überspannungsauslöser 16, der den Spannungsabfall zwischen zwei Abgriffspunkten 13A und 13B des Strombegrenzers 13 abgreift, und ein in Reihe zum Strombegrenzer 13 vor die Last 12 in den Leitungsabzweig 17 geschaltetes Schaltrelais 14. Das Schaltrelais 14 wird von dem Überspannungsauslöser 16 bei Überschreiten einer Grenzspannung am Strombegrenzer 13 ausgelöst (geöffnet) zur galvanischen Trennung des Verbrauchers 12 vom Netz (R) im Kurzschlußfall. Das Schaltrelais 14 muß dabei nicht besonders schnell sein noch werden seine Kontakte durch Lichtbögen bei der Strombegrenzung beansprucht, da der elektronische Strombegrenzer 13 sehr schnell in deutlich weniger als einer Millisekunde den Strom begrenzt.

## Patentansprüche

1. Halbleiteranordnung umfassend
a) ein erstes Halbleitergebiet (2) mit einer ersten Oberfläche (20) und mit wenigstens einem Kontaktgebiet (5) an dieser ersten Oberfläche (20),
b) wenigstens ein zweites Halbleitergebiet (3), das mit dem ersten Halbleitergebiet (2) einen ersten p-n-Übergang bildet,
c) wenigstens ein drittes Halbleitergebiet (4), das an der ersten Oberfläche (20) des ersten Halbleitergebietes (2) angeordnet ist und mit dem ersten Halbleitergebiet (2) einen zweiten p-n-Übergang bildet,
d) eine erste Elektrode (7), die sowohl das wenigstens eine Kontaktgebiet (5) des ersten Halbleitergebiet (2) als auch das dritte Halbleitergebiet (4) an seiner nicht an das erste Halbleitergebiet (2) angrenzenden Oberfläche (40) ohmsch kontaktiert,
e) eine zweite Elektrode (6), die das erste Halbleitergebiet (2) kontaktiert, und
f) wenigstens ein Kanalgebiet (22), das innerhalb eines zwischen den beiden Elektroden (6, 7) durch das erste Halbleitergebiet (2) verlaufenden Strompfads liegt,
**dadurch gekennzeichnet, daß**
g) das Kanalgebiet (22) von dem ersten und dem zweiten p-n-Übergang derart umgeben ist, daß bei Erreichen eines vorgegebenen Sättigungsstromes zwischen den beiden Elektroden (6, 7) eine Abschnürung des Kanalgebiets (22) zwischen dem zweiten und dritten Halbleitergebiet (3 bzw. 4) mittels Verarmungszonen (23, 24) der beiden p-n-Übergänge erfolgt und der Strom nach erfolgter Abschnürung auf einen Begrenzungsstrom unterhalb des Sättigungsstromes sinkt.

2. Halbleiteranordnung nach Anspruch 1, bei der das dritte Halbleitergebiet (4) das Kontaktgebiet (5) parallel zur ersten Oberfläche (20) des ersten Halbleitergebietes (2) umschließt.

3. Halbleiteranordnung umfassend
a) ein erstes Halbleitergebiet (2) mit einer ersten Oberfläche (20) und mit wenigstens einem Kontaktgebiet (5) an dieser ersten Oberfläche (20),
b) wenigstens ein zweites Halbleitergebiet (3), das mit dem ersten Halbleitergebiet (2) einen p-n-Übergang bildet,
c) eine erste Elektrode (7), die auf jedem Kontaktgebiet (5) des ersten Halbleitergebietes (2) jeweils einen ohmschen Kontakt bildet,
e) eine zweite Elektrode (6), die das erste Halbleitergebiet (2) kontaktiert, und
f) wenigstens ein Kanalgebiet (22), das innerhalb eines zwischen den beiden Elektroden (6, 7) durch das erste Haibleitergebiet (2) verlaufenden Strompfads liegt,
**dadurch gekennzeichnet, daß**
g) die erste Elektrode (7) auf einem außerhalb des wenigstens einen Kontaktgebietes (5) liegenden Bereich des ersten Halbleitergebietes (2) einen Schottky-Kontakt bildet,
h) das Kanalgebiet (22) von dem p-n-Übergang und dem Schottky-Kontakt derart umgeben ist, daß bei Erreichen eines vorgegebenen Sättigungsstromes zwischen den beiden Elektroden (6, 7) eine Abschnürung des Kanalgebiets (22) zwischen dem zweiten Halbleitergebiet (3) und dem Schottky-Kontakt mittels Verarmungszonen (23, 70) des p-n-Übergangs bzw. des Schottky-Kontakts erfolgt und der Strom nach erfolgter Abschürung auf einen Begrenzungsstrom unterhalb des Sättigungsstromes sinkt.

4. Halbleiteranordnung nach einem der vorhergehenden Ansprüche, bei der das zweite Halbleitergebiet (3) innerhalb des ersten Halbleitergebietes (2) unterhalb des Kontaktgebiets (5) angeordnet ist und sich in allen Richtungen parallel zur ersten Oberfläche (20) des ersten Halbleitergebiets (2) weiter erstreckt als das Kontaktgebiet (5).

5. Halbleiteranordnung nach einem der vorhergehenden Ansprüche, bei der die zweite Elektrode (6) an einer von der ersten Oberfläche (20) abgewandten zweiten Oberfläche (21) des ersten Halbleitergebietes (2) angeordnet ist.

6. Halbleiteranordnung nach einem der vorhergehenden Ansprüche, bei der das erste Halbleitergebiet (2) an seiner ersten Oberfläche (20) mehrere Kontaktgebiete (5) aufweist.

7. Halbleiteranordnung nach Anspruch 6, bei der unterhalb der Kontaktgebiete (5) ein zusammenhängendes zweites Halbleitergebiet (3) angeordnet ist, das in allen Richtungen parallel zur ersten Oberfläche (20) des ersten Halbleitergebietes (2) weiter ausgedehnt ist als die Gesamtheit der Kontaktgebiete (5).

8. Halbleiteranordnung nach Anspruch 4 und Anspruch 6, bei der unterhalb jedes Kontaktgebietes (5) ein zugehöriges zweites Halbleitergebiet (3) im ersten Halbleitergebiet (2) angeordnet ist.

9. Halbleiteranordnung nach Anspruch 7, bei der durch Öffnungen in dem zusammenhängenden zweiten Halbleitergebiet (3) jeweils Kanalgebiete (29) des ersten Halbleitergebietes (2) verlaufen, die im Strompfad elektrisch in Reihe zu jeweils wenigstens einem der den Kontaktgebieten (5) zugeordneten Kanalgebieten (22) liegen.

10. Halbleiteranordnung nach Anspruch 8, bei der zwischen den den Kontaktgebieten (5) zugeordneten zweiten Halbleitergebiete (3) zusätzliche Kanalgebiete (29) des ersten Halbleitergebietes (2) verlaufen, die im Strompfad elektrisch in Reihe zu jeweils wenigstens einem der den Kontaktgebieten (5) zugeordneten Kanalgebieten (22) liegen.

11. Halbleiteranordnung nach Anspruch 10, bei der die zusätzlichen Kanalgebiete (29) im wesentlichen vertikal zur ersten Oberfläche (20) verlaufen.

12. Halbleiteranordnung nach einem der vorhergehenden Ansprüche, bei der die Halbleitergebiete (2,3,4) aus einem Halbleiter mit einem Bandabstand von wenigstens 2 eV gebildet sind.

13. Halbleiteranordnung nach Anspruch 12, bei der die Halbleitergebiete (2,3,4) aus Siliciumcarbid (SiC) gebildet sind.

14. Halbleiteranordnung nach einem der vorhergehenden Ansprüche, bei der die erste Elektrode (7) wenigstens teilweise aus Nickel besteht.

15. Halbleiteranordnung nach einem der vorhergehenden Ansprüche, bei der die erste Elektrode (7) an jedes zweite Halbleitergebiet (3) derart elektrisch angekoppelt ist, daß sich eine vorgegebene Relaxationszeit für gespeicherten Ladungen im zweiten Halbleitergebiet (3) ergibt.

16. Halbleiteranordnung nach Anspruch 15, bei der die erste Elektrode (7) und/oder eine elektrische Verbindung (61) zwischen der ersten Elektrode (7) und jedem zweiten Halbleitergebiet (3) wenigstens teilweise aus Polysilicium besteht.

17. Halbleiteranordnung nach einem der vorangegangenen Ansprüche, bei der das erste Halbleitergebiet (2) in jedem Kontaktgebiet (5) eine höhere Ladungsträgerkonzentration aufweist als in den übrigen Bereichen.

18. Halbleiteranordnung nach einem der vorhergehenden Ansprüche, bei der der Sättigungsstrom wenigstens das Fünffache des Begrenzungsstromes beträgt.

19. Verwendung wenigstens einer Halbleiteranordnung nach einem der vorhergehenden Ansprüche für einen Strombegrenzer (13) zum Begrenzen von Gleichströmen zwischen einer Stromquelle (R) und einem elektrischen Verbraucher (12), wobei eine Elektrode (7) der Halbleiteranordnung mit der Stromquelle (R) und die andere Elektrode (6) mit dem Verbraucher (12) elektrisch verbunden ist.

20. Verwendung mindestens zweier Halbleiteranordnungen nach einem der Ansprüche 1 bis 18 für einen Strombegrenzer (13) zum Begrenzen von Wechselströmen zwischen einer Stromquelle (R) und einem elektrischen Verbraucher (12), wobei zwei der Halbleiteranordnungen antiseriell zwischen die Stromquelle (R) und den Verbraucher (12) geschaltet sind.

## Claims

1. Semiconductor arrangement comprising
a) a first semiconductor region (2) having a first surface (20) and having at least one contact region (5) at this first surface (20),
b) at least one second semiconductor region (3), which forms a first p-n junction with the first semiconductor region (2),
c) at least one third semiconductor region (4), which is arranged at the first surface (20) of the first semiconductor region (2) and forms a second p-n junction with the first semiconductor region (2),
d) a first electrode (7), which makes ohmic contact both with the at least one contact region (5) of the first semiconductor region (2) and with the third semiconductor region (4) at its surface (40) which does not adjoin the first semiconductor region (2), and
e) a second electrode (6), which makes contact with the first semiconductor region (2), and
f) at least one channel region (22), which lies within a current path running between the two electrodes (6, 7) through the first semiconductor region (2),
**characterized in that**
g) the channel region (22) is surrounded by the first and second p-n junctions in such a way that when a predetermined saturation current is reached between the two electrodes (6, 7), the channel region (22) is pinched off between the second and third semiconductor regions (3 and 4, respectively) by means of depletion zones (23, 24) of the two p-n junctions and, after pinch-off has taken place, the current falls to a limit current below the saturation current.

2. Semiconductor arrangement according to Claim 1, in which the third semiconductor region (4) encloses the contact region (5) parallel to the first surface (20) of the first semiconductor region (2).

3. Semiconductor arrangement comprising
a) a first semiconductor region (2) having a first surface (20) and having at least one contact region (5) at this first surface (20),
b) at least one second semiconductor region (3) which forms a p-n junction with the first semiconductor region (2),
c) a first electrode (7), which forms a respective ohmic contact on each contact region (5) of the first semiconductor region (2),
e) a second electrode (6), which makes contact with the first semiconductor region (2), and
f) at least one channel region (22), which lies within a current path running between the two electrodes (6, 7) through the first semiconductor region (2),
**characterized in that**
g) the first electrode (7) forms a Schottky contact on a zone of the first semiconductor region (2) which lies outside the at least one contact region (5),
h) the channel region (22) is surrounded by the p-n junction and the Schottky contact in such a way that when a predetermined saturation current is channel region (22) is pinched off between the second semiconductor region (3) and the Schottky contact by means of depeletion zones (23, 70) of the p-n junction and of the Schottky contact, respectively, and after pinch-off has taken place, the current falls to a limit current below the saturation current.

4. Semiconductor arrangement according to one of the preceding claims, in which the second semiconductor region (3) is arranged within the first semiconductor region (2) below the contact region (5) and extends further than the contact region (5) in all directions parallel to the first surface (20) of the first semiconductor region (2).

5. Semiconductor arrangement according to one of the preceding claims, in which the second electrode (6) is arranged on a second surface (21) of the first semiconductor region (2), said second surface being remote from the first surface (20).

6. Semiconductor arrangement according to one of the preceding claims, in which the first semiconductor region (2) has a plurality of contact regions (5) at its first surface (20).

7. Semiconductor arrangement according to Claim 6, in which a coherent second semiconductor region (3) is arranged below the contact regions (5) and is extended further than the contact regions (5) in their entirety in all directions parallel to the first surface (20) of the first semiconductor region (2).

8. Semiconductor arrangement according to Claim 4 and Claim 6, in which, below each contact region (5) an associated second semiconductor region (3) is arranged in the first semiconductor region (2).

9. Semiconductor arrangement according to Claim 7, in which respective channel regions (29) of the first semiconductor region (2) run through openings in the coherent second semiconductor region (3) and, in the current path, are electrically connected in series with in each case at least one of the channel regions (22) assigned to the contact regions (5).

10. Semiconductor arrangement according to Claim 8, in which additional channel regions (29) of the first semiconductor region (2) run between the second semiconductor regions (3) assigned to the contact regions (5) and, in the current path, are electrically connected in series with in each case at least one of the channel regions (22) assigned to the contact regions (5).

11. Semiconductor arrangement according to Claim 10, in which the additional channel regions (29) run essentially vertically with respect to the first surface (20).

12. Semiconductor arrangement according to one of the preceding claims, in which the semiconductor regions (2, 3, 4) are formed from a semiconductor having an energy gap of at least 2 eV.

13. Semiconductor arrangement according to Claim 12, in which the semiconductor regions (2, 3, 4) are formed from silicon carbide (SiC).

14. Semiconductor arrangement according to one of the preceding claims, in which the first electrode (7) is at least partly composed of nickel.

15. Semiconductor arrangement according to one of the preceding claims, in which the first electrode (7) is electrically coupled to each second semiconductor region (3) in such a way as to produce a predetermined relaxation time for stored charges in the second semiconductor region (3).

16. Semiconductor arrangement according to Claim 15, in which the first electrode (7) and/or an electrical connection (61) between the first electrode (7) and each second semiconductor region (3) is at least partly composed of polysilicon.

17. Semiconductor arrangement according to one of the preceding claims, in which the first semiconductor region (2) has a higher charge carrier concentration in each contact region (5) than in the remaining zones.

18. Semiconductor arrangement according to one of the preceding claims, in which the saturation current is at least five times the limit current.

19. Use of at least one semiconductor arrangement according to one of the preceding claims for a current limiter (13) for limiting direct currents between a current source (R) and an electrical load (12), where one electrode (7) of the semiconductor arrangement is electrically connected to the current source (R) and the other electrode (6) is electrically connected to the load (12).

20. Use of at least two semiconductor arrangements according to one of Claims 1 to 18 for a current limiter (13) for limiting alternating currents between a current source (R) and an electrical load (12) where two of the semiconductor arrangements are reverse-connected in series between the current source (R) and the load (12).

## Revendications

1. Dispositif à semiconducteur comprenant
a) une première zone (2) semiconductrice ayant une première surface (20) et au moins une zone (5) de contact sur cette première surface (20),
b) au moins une deuxième zone (3) semiconductrice qui forme, avec la première zone (2) semiconductrice, une première jonction p-n,
c) au moins une troisième zone (4) semiconductrice qui est disposée sur la première surface (20) de la première zone (2) semiconductrice et qui forme avec la première zone (2) semiconductrice une deuxième jonction p-n,
d) une première électrode (7) qui est en contact ohmique tant avec la au moins une zone (5) de contact de la première zone (2) semiconductrice qu'avec la troisième zone (4) semiconductrice sur sa surface (4) qui n'est pas adjacente à la première (2) semiconductrice,
e) une deuxième électrode (6) qui est en contact avec la première zone (2) semiconductrice, et
f) au moins une zone (22) de canal qui se trouve à l'intérieur d'un trajet de courant s'étendant entre les deux électrodes (6, 7) et passant dans la première zone (2) semiconductrice,
**caractérisé en ce que**
g) la zone (22) de canal est entourée de la première et de la deuxième jonctions p-n de manière à produire, lorsqu'est atteint un courant de saturation donné à l'avance entre les deux électrodes (6, 7), un étranglement de la zone (22) de canal entre les deuxième et troisième zones (3 et 4) semiconductrices au moyen de zones (23, 24) d'appauvrissement des deux jonctions p-n et à abaisser le courant après que l'étranglement s'est produit jusqu'à un courant de limitation inférieur au courant de saturation.

2. Dispositif à semiconducteur suivant la revendication 1, dans lequel la troisième zone (4) semiconductrice de la zone (5) de contact entoure la première zone (2) semiconductrice parallèlement à la première surface.

3. Dispositif à semiconducteur comprenant
a) une première zone (2) semiconductrice ayant une première surface (20) et au moins une zone (5) de contact sur cette première surface (20),
b) au moins une deuxième zone (3) semiconductrice qui forme, avec la première zone (2) semiconductrice, une première jonction p-n,
c) une première électrode (7) qui forme sur chaque (5) de contact de la première zone (2) semiconductrice respectivement un contact ohmique,
e) une deuxième électrode (6) qui est en contact avec la première zone (2) semiconductrice, et
f) au moins une zone (22) de canal qui se trouve à l'intérieur d'un trajet de courant s'étendant entre les deux électrodes (6, 7) et passant dans la première zone (2) semiconductrice,
**caractérisé en ce que**
g) la première électrode (7) forme un contact de Schottky sur une partie de la première zone (2) semiconductrice se trouvant à l'extérieur de la au moins une zone (5) de contact,
h) la zone (22) de contact est entourée de la jonction p-n et du contact de Schottky de façon à produire, lorsqu'un courant de saturation donné à l'avance est atteint entre les deux électrodes (6, 7), un étranglement de la zone (22) de canal entre la deuxième zone (3) semiconductrice et le contact de Schottky au moyen de zones (23, 70) d'appauvrissement de la jonction p-n ou du contact Schottky et à abaisser le courant après que l'étranglement s'est produit jusqu'à un courant de limitation inférieur au courant de saturation.

4. Dispositif suivant l'une des revendications précédentes, dans lequel la deuxième zone (3) semiconductrice est disposée à l'intérieur de la première zone (2) semiconductrice en dessous de la zone (5) de contact et s'étend dans toutes les directions parallèlement à la première surface (1) de la première zone (2) semiconductrice au-delà de la zone (5) de contact.

5. Dispositif suivant l'une des revendications précédentes, dans lequel la deuxième électrode (6) est disposée sur une deuxième surface (21) de la première zone (2) semiconductrice qui est éloignée de la première surface (20).

6. Dispositif suivant l'une des revendications précédentes, dans lequel la première zone (2) semiconductrice a plusieurs zones (5) de contact sur sa première surface.

7. Dispositif suivant la revendication 6, dans lequel il est prévu, en dessous des zones (5) de contact, une deuxième zone (3) semiconductrice d'un seul tenant, qui s'étend dans toutes les directions parallèlement à la première surface (20) de la première zone (2) semiconductrice au-delà de l'ensemble des zones (5) de contact.

8. Dispositif suivant la revendication 4 et la revendication 6, dans lequel il est prévu en dessous de chaque zone (5) de contact une deuxième zone (3) semiconductrice associée dans la première zone (2) semiconductrice.

9. Dispositif suivant la revendication 7, il passe par les ouvertures ménagées dans la deuxième zone (3) semiconductrice d'un seul tenant respectivement des zones (29) de canal de la première zone (2) semiconductrice qui sont dans le trajet de courant électriquement en série avec respectivement au moins l'une des zones (22) de canal associées aux zones (5) de contact.

10. Dispositif suivant la revendication 8, dans lequel il s'étend, entre les deuxièmes zones (3) semiconductrices associées aux zones (5) de contact des zones (29) supplémentaires de contact de la première zone (2) semiconductrice qui sont dans le trajet de courant électriquement en série avec respectivement au moins l'une des zones (22) de canal associées aux zones (5) de contact.

11. Dispositif suivant la revendication 10, dans lequel les zones (29) supplémentaires de canal sont sensiblement verticales par rapport à la première surface (20).

12. Dispositif suivant l'une des revendications précédentes, dans lequel les zones (2, 3, 4) semiconductrices sont en un semiconducteur ayant une bande interdite d'au moins 2 eV.

13. Dispositif suivant la revendication 12, dans lequel les zones (2, 3, 4) semiconductrices sont en carbure de silicium (SiC).

14. Dispositif suivant l'une des revendications précédentes, dans lequel la première électrode (7) est au moins en partie en nickel.

15. Dispositif suivant l'une des revendications précédentes, dans lequel la première électrode (7) est couplée électriquement à chaque deuxième zone (3) semiconductrice, de façon à produire une durée de relaxation donnée à l'avance pour des charges emmagasinées dans la deuxième zone (3) semiconductrice.

16. Dispositif suivant la revendication 15, dans lequel la première électrode (7) et/ou une connexion (61) électrique entre la première électrode (7) et chaque deuxième zone (3) semiconductrice est au moins en partie en polysilicium.

17. Dispositif suivant l'une des revendications précédentes, dans lequel la première zone (2) semiconductrice dans chaque zone (5) de contact a une concentration de porteurs de charge plus grande que dans les autres parties.

18. Dispositif suivant l'une des revendications précédentes, dans lequel le courant de saturation représente au moins cinq fois le courant de limitation.

19. Utilisation d'au moins un dispositif à semiconducteur suivant l'une des revendications précédentes pour un limiteur (13) de courant en vue de limiter les courants continus entre une source (R) de courant et un appareil (12) consommant de l'électricité, une électrode (7) du dispositif à semiconducteur étant reliée électriquement à la source (R) de courant et l'autre électrode (6) à l'appareil (12) consommateur.

20. Utilisation d'au moins deux dispositifs à semiconducteur suivant l'une des revendications 1 à 18 pour un limiteur (13) de courant qui peut limiter des courants alternatifs entre une source (R) de courant et un appareil (12) consommant de l'électricité, deux dispositifs à semiconducteur étant montés tête-bêche entre la source (R) de courant et l'appareil (12) consommateur.
